# EUROPÄISCHE PATENTANMELDUNG

(11) **EP 1 189 250 A1**
(43) Veröffentlichungstag der Anmeldung: **20.03.2002**
(21) Anmeldenummer: 01117371.3
(22) Anmeldetag: 18.07.2001
(51) Int. Cl.: H01H 11/00

(54) **Funktionell asymmetrische Schaltungsträgeranordnung mit spiegelsymmetrischer Bauteileanordnung**

(30) Priorität: 07.08.2000 DE 10038390
(71) Anmelder: Cherry GmbH, 91275 Auerbach (DE)
(72) Erfinder: Raschke, Dirk, 91275 Auerbach (DE)
(74) Vertreter: Neugebauer, Jürgen, Dipl.-Phys.

(57) **Zusammenfassung**

Die Erfindung betrifft eine Schaltungsträgerordnung, welche einen linkshändigen (1) und einen dazu spiegelungssymmetrischen rechtshändigen (1') Schaltungsträger mit jeweiligen elektrischen und/oder elektronischen und/oder elektromechanischen Bauelementen (2 - 6 bzw. 2' - 6') und einer diese Bauelemente elektrisch verbindenden Leiteranordnung (7 bzw, 7') umfaßt. Bei spiegelungssymmetrischer Ausrichtung des linkshändigen (1) und des rechtshändigen (1') Schaltungsträgers längs einer Spiegelungsachse (g) sind sämtliche Bauelemente (2 - 6) auf dem linkshändigen (1) und dem rechtshändigen (1') Schaltungsträger in symmetrisch gespiegelter Weise positioniert. Jedoch sind die schaltungsfunktionellen Kontaktbelegungen (A - F) mindestens eines schaltungsfunktionell spiegelungsinvarianten Bauelements (2 bzw. 2') auf dem linkshändigen (1) und dem rechtshändigen (1') Schaltungsträger nicht spiegelsymmetrisch zueinander. Diese Anordnung eignet sich zur Verwendung bei Einsatzgebieten, wo in räumlich-geometrischer Hinsicht eine spiegelsymmetrische Anordnung der Schaltungsträger (2, 2') gewünscht ist, jedoch die Bauteile auf dem rechtshändigen Schaltungsträger schaltungsfunktionell nicht spiegelsymmetrisch zu den Bauteile auf dem linkshändigen Schaltungsträger sein sollen.

## Beschreibung

Die vorliegende Erfindung bezieht sich auf eine Schaltungsträgeranordnung, die Paare von "linkshändigen" und "rechtshändigen " Schaltungsträgern mit zueinander spiegelungssymmetrischer Positionierung von elektrischen und/oder elektronischen und/oder elektromechanischen Bauteilen umfaßt, und insbesondere Schaltungsträgeranordnungen nach dem Oberbegriff des Anspruchs 1, wie sie aus der DE 39 04 771 C1, DE 44 05 566 A1 und der US 5,612,777 jeweils bekannt sind.

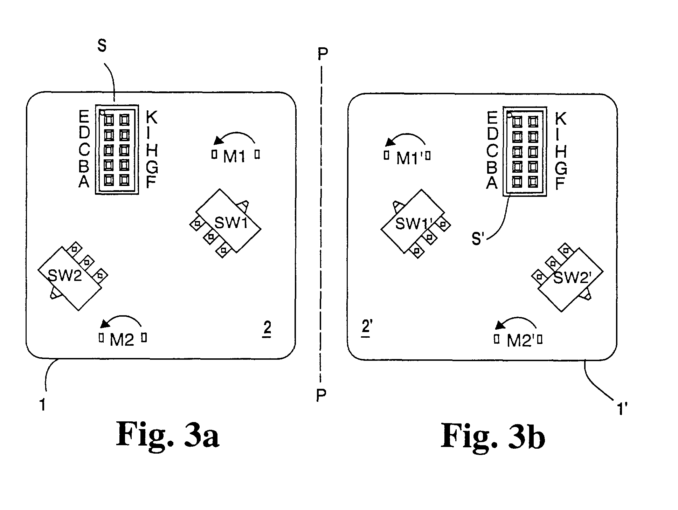

Die der vorliegenden Erfindung zugrundeliegende Aufgabe wird beispielhaft in Verbindung mit Fig. 3a bis 6b erläutert.

Bei der Steuerung von Autotürschlössern werden heutzutage elektromechanische Schließvorrichtungen eingesetzt. Fig. 3a bzw. 3b zeigen schematisch eine Draufsicht in die offenen Gehäuseschalen 1, 1' eines Schaltungsträgers 2, 2' für eine linke bzw. eine rechte Autotür.

Die Schaltungsträger 2, 2' sind Kunststoffträgerteile, in die elektrische Leiter eingebettet sind, die die elektrischen und/oder elektronischen und/oder elektromechanischen Bauteile auf den beiden Schaltungsträgern 2, 2' miteinander verbinden.

In Fig. 3a und 3b sind die auf den beiden Schaltungsträgern 2 bzw. 2' beispielhaft angebrachten Bauteile ein erster Schalter SW1 bzw. SW1', ein zweiter Schalter SW2 bzw. SW2', ein erster Elektromotor M1 bzw. M1', ein zweiter Elektromotor M2 bzw. M2' und ein Stecker S bzw. S'. Die Elektromotoren sind jeweils durch die Kontaktanschlüsse und die Motordrehrichtung symbolisiert.

In der Serienfertigung im Automobilbau liegt nunmehr eine Situation vor, derzufolge die beiden in Fig. 3a und 3b für eine linke und eine rechte Automobiltür gezeigten Schaltungsträger 2, 2' und deren Gehäuseschalen 1, 1' spiegelsymmetrisch ausgeführt sein müssen, um auf beiden Seiten des Kraftfahrzeugs in zueinander spiegelsymmetrischen Positionen und Orientierungen eingebaut werden zu können.

Denkt man sich zwischen die in Fig. 3a und 3b gezeigten links- und rechtshändigen Varianten eines Schaltungsträgers 2, 2' eine Spiegelebene P ausgerichtet, so sind also aufgrund der Symmetrieanforderungen die Positionen und Orientierungen der auf dem linkshändigen Schaltungsträger 2 angebrachten Bauteile spiegelsymmetrisch zu den Positionierungen und Orientierungen der auf dem rechtshändigen Schaltungsträger 2' angebrachten Bauteile.

Insbesondere in der Kraftfahrzeugserienfertigung existiert aus Gründen der Vereinfachung der Materialwirtschaft und der Kostensenkung bei der Variantenkonstruktion die Randbedingung, daß die Zahl der zu entwickelnden und vorzuhaltenden Bauteilvarianten minimiert sein soll. Dies bedeutet beispielhaft, daß bei den in Fig. 3a und 3b gezeigten Bauteilen keine jeweils spezifisch linkshändige und spezifisch rechtshändige Variante vorzusehen ist. Durch die Verwendung nur einer Variante von Bauteilen wird auch jeweils der Handhabungsaufwand in der Montage reduziert und die Komplexitätsanforderungen an Handhabungsautomaten gesenkt.

Vielmehr ist in der Serienfertigungspraxis erwünscht, daß die in Fig. 3a gezeigten Motoren M1 und M2, die Schalter SW1 und SW2 und der Stecker S vollkommen identisch sind zu den in Fig. 3b gezeigten Motoren M1' und M2', den Schaltern SW1' und SW2' und dem Stecker S'.

In Hinsicht auf ihre schaltungsfunktionelle Kontaktbelegung und Wirkungsweise sind die in Fig. 3a und 3b gezeigten Bauteile also nicht spiegelsymmetrisch zueinander: Die identischen Motoren M1 in Fig. 3a und und M1' in Fig. 3b drehen sich z. B. beide gegen den Uhrzeigersinn (und nicht gegensinnig zueinander), die Steckerpositionen A - K der Stecker S bzw. S' in den Fig. 3a und 3b sind ebenfalls nicht spiegelungssymmetrisch zueinander, sondern entsprechen einander.

Es liegt also hinsichtlich der räumlich-geometrischen Einbausituation für die linkshändige und die rechtshändige Variante des Schaltungsträgers Spiegelsymmetrie vor, hinsichtlich der Schaltungsfunktionalität aber Asymmetrie.

Diese Identität der im linkshändigen und der rechtshändigen Aufbau gezeigten Bauteile führt in der Praxis beim Bau von Autotürschließvorrichtungen nun auch dazu, daß für die an den Steckern anzubringenden Gegenstecker und den daran angeschlossenen Kabelbäumen nicht jeweils eine linkshändige und eine rechtshändige Variante vorzusehen ist, sondern jeweils nur eine identische Variante, die auf der linken und der rechten Fahrzeugseite in symmetrischer Positionierung und Orientierung in räumlich-geometrischer Hinsicht einzubauen ist, aber in schaltungsfunktioneller Hinsicht asymmetrisch ist.

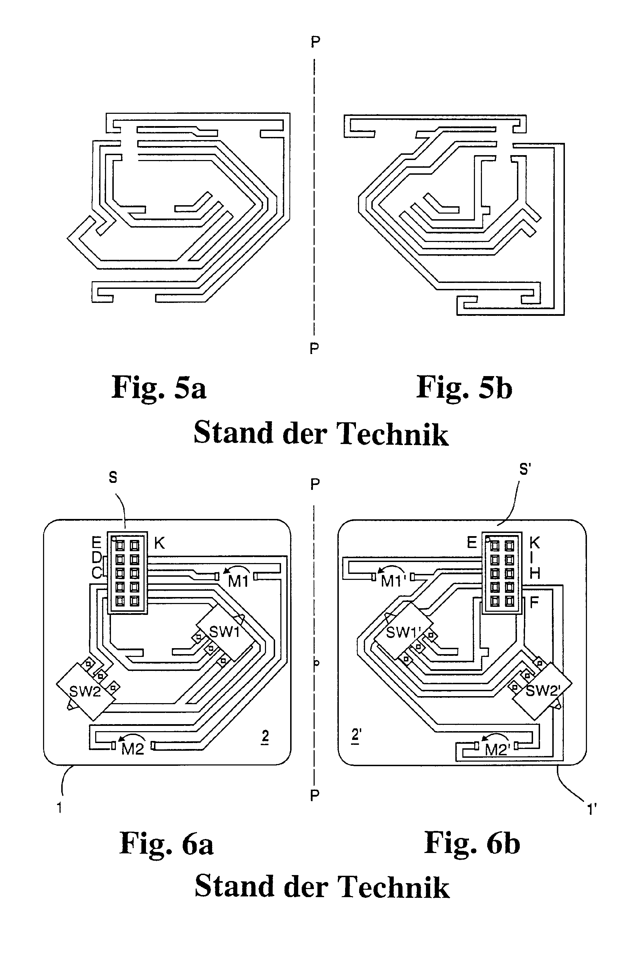

Da beiden Schaltungsträgern in Fig. 3a und 3b exakt derselbe Schaltplan und dieselbe Kontaktpinbelegung zugeordnet ist, wie in Fig. 4 beispielhaft gezeigt, müssen nunmehr für die Leiteranordnungen in der linkshändigen und der rechtshändigen Ausführungsform des Schaltungsträgers 2, 2' zwei verschiedene Layouts für die Leiteranordnung entworfen werden, um die linkshändige und die rechtshändige Variante des Schaltungsträgers 2, 2' schaltungsfunktionell korrekt kontaktieren zu können.

Dieser Forderung begegnet man in der Praxis bis heute dadurch, daß man für den linkshändigen Schaltungsträger 2 ein anderes Layout für die Leiteranordnung wählt, als für den rechtshändigen Schaltungsträger 2'. Dies ist in Fig. 5a und 5b für je ein Layout für eine linkshändige und eine rechtshändige Leiteranordnung gezeigt.

Die Fig. 6a und 6b zeigen, in einer den Fig. 3a und 3b entsprechenden Darstellungen die in Fig. 5a und 5b gezeigten Leiteranordnungen eingebettet in Schaltungsträger 2, 2'. Dies geschieht bei einem Schaltungsträger üblicherweise durch Einbetten der Schaltungsträger in eine schützende Kunststoffmasse.

Verwendet man z.B. Stanzgitter für die Leiteranordnungen, so entsprechen die in Fig. 5a und 5b gezeigten Layouts zwei verschiedenen Stanzgittern, die jeweils in den linkshändigen bzw. rechtshändigen Schaltungsträger 2 bzw. 2' einzubetten sind. Selbstverständlich werden zur Herstellung der Stanzgitter zwei verschiedene Stanz-Biegewerkzeuge gebraucht. Dies führt in der automatisierten Fertigungspraxis dazu, daß man für die beiden Stanzgittervarianten zwei komplett voneinander getrennte Fertigungsstraßen einrichten muß, mit jeweils spezifisch an das linkshändige und das rechtshändige Stanzgitter angepaßten Stanz-Biegewerkzeugen und Handhabungsautomaten. Durch Verwendung unterschiedlicher Stanz-Biegewerkzeuge für das linkshändige und das rechtshändige Stanzgitter ist es möglich, an den beiden Stanzgittern durch Umbiegen frei stehender Stanzgitterabschnitte Kontaktstifte (nicht gezeigt) auszubilden, die eine Kontaktierung der Bauteile in der in Fig. 6a und 6b gezeigten Weise an den beiden Stanzgittern so ermöglichen, daß die Bauteile auf dem linkshändigen und dem rechtshändigen Stanzgitter wie gewünscht spiegelsymmetrisch zueinander positioniert sind.

Verwendet man Leiterträger mit aufgebrachten Leiterbahnenanordnungen z.B. in Form starrer Leiterplatten oder flexibler bedruckter Leiterfolien anstelle von Stanzgittern, so treten auch hier ähnliche Probleme auch. Auch bei solchen mit Leiterbahnen versehenen Leiterträgern sind jeweils zwei Varianten mit unterschiedlichen Leiteranordnungen (Layouts) für die linkshändige und die rechtshändige Ausführungsform bereitzustellen. Dies bedeutet z.B., daß bei fotolithographischen Verfahren zur Leiterplattenherstellung zwei verschiedene Arten von Belichtungsmasken verwendet werden müssen.

In jedem Fall verbleibt das Problem, daß zwei verschiedene Varianten von Leiteranordnungen in der Serienfertigung zu handhaben sind. Dadurch wird das vorgegebene Ziel der Variantenminimierung der verwendeten Bauteile und der Minimierung des Handhabungsaufwands nicht optimal erreicht.

Verwendet man Leiterträger mit auf beiden Seiten aufgebrachten unterschiedlichen Layouts für die Leiterbahnenanordnungen (z.B. eine doppelseitig mit Leiterbahnen versehene Leiterplatte oder eine doppelseitig bedruckte flexible Leiterfolie), so hat man zwar nur noch einen Leiterträger. Dieser muß jedoch beidseitig mit Leiterbahnen versehen werden, was je nach verwendetem Verfahren doch einen erheblichen Fertigungs- und damit auch Kostenaufwand bedeuten kann.

Aufgabe der vorliegenden Erfindung ist es nunmehr, eine Schaltungsträgerordnung vorzuschlagen, welche einen linkshändigen und einen rechtshändigen Schaltungsträger mit jeweils spiegelsymmetrisch zueinander angeordneten elektrischen und/oder elektronischen und/oder elektromechanischen Bauelementen vorsieht, bei denen die Anzahl der zu für eine Serienfertigung vorzuhaltenden Bauelementvarianten einschließlich der Anzahl der vorzuhaltenden Leiteranordnungsvarianten für den linkshändigen und den rechtshändigen Schaltungsträger minimiert ist.

Diese Aufgabe wird durch die Maßnahmen des Anspruchs 1 gelöst. Die abhängigen Ansprüche betreffen vorteilhafte Ausführungsformen der vorliegenden Erfindung.

Neben der Serienfertigung von Schaltungsträgern für elektromechanische Schließvorrichtungen in Autotüren tritt dieselbe Problematik, daß Schaltungsträger mit räumlich-geometrischer Symmetrie bezüglich der Positionierung der von Bauteilen, aber schaltungsfunktioneller Asymmetrie dieser symmetrisch positionierten Bauteile, erwünscht sind, z.B. auch in Bereichen auf wie der Serienfertigung von Schaltungsträgern für die Verstellung eines linken und eines rechten Autositzes, der Serienfertigung von Fahrzeugen mit links bzw. rechts positionierten Fahrzeuglenksäulen, oder ganz allgemein dort, wo eine linkshändige und eine in räumlich-geometrischer Hinsicht dazu spiegelsymmetrische rechtshändige Variante eines Schaltungsträgers unter Verwendung eines einzigen Typs von elektrischen und/oder elektronischen Bauteilen zu fertigen sind.

Die Vorteile und Merkmale der vorliegenden Erfindung ergeben sich auch aus den nachfolgend erläuterten Ausführungsbeispielen in Verbindung mit den Zeichnungen.

Es zeigen:
- Fig. 1a: eine Draufsicht auf die linkshändige Variante eines erfindungsgemäßen Schaltungsträgers samt darin integrierter Leiteranordnung;
- Fig. 1b: eine Draufsicht auf einen dem in Fig. 1a gezeigten linkshändigen Schaltungsträger entsprechenden rechtshändigen Schaltungsträger;
- Fig. 2a und 2b: Draufsichten auf eine linkshändige und eines rechtshändige Variante der in Fig. 1a bzw. 1b gezeigten Leiteranordnungen in Form je eines Stanzgitters;
- Fig. 3a und 3b: Draufsichten auf eine linkshändige und eines rechtshändige Variante eines Schaltungsträgers zur Erläuterung der der Erfindung zugrundeliegenden Aufgabe, sowie die darauf angebrachten Bauteile, wobei die zugeordneten Leiteranordnungen verdeckt sind;
- Fig. 4: eine schematische Darstellung eines Schaltplans und einer Steckkontaktbelegung eines Steckers für die in Fig. 3a und 3b gezeigte linkshändige und rechtshändige Variante eines Schaltungsträgers;
- Fig. 5a und 5b: Draufsichten auf eine linkshändige bzw. eine rechtshändige Variante konventioneller Leiteranordnungen in Form von Stanzgittern zum Einsatz in den in Fig. 3a bzw. 3b gezeigten Schaltungsträgern;
- Fig. 6a und 6b: den Fig. 3a und 3b entsprechende Ansichten mit Darstellung der in den beiden Schaltungsträgern integrierten Leiteranordnungen aus Fig. 5a und 5b;
- Fig. 7: eine Draufsicht auf einen in einer erfindungsgemäßen Schaltungsträgeranordnung bevorzugterweise verwendeten Stecker mit zweireihig parallel nebeneinanderliegend angeordneten Anschlußkontakten; und
- Fig. 8a und 8b: perspektivische Darstellungen auf in einer erfindungsgemäßen Schaltungsträgeranordnung einsetzbare linkshändige und rechtshändige Varianten eines einseitig mit Leiterbahnen versehenen Leiterträgers in Form einer starren Leiterplatte oder einer flexiblen Leiterfolie mit Durchkontaktierungen der Leiterbahnebene.

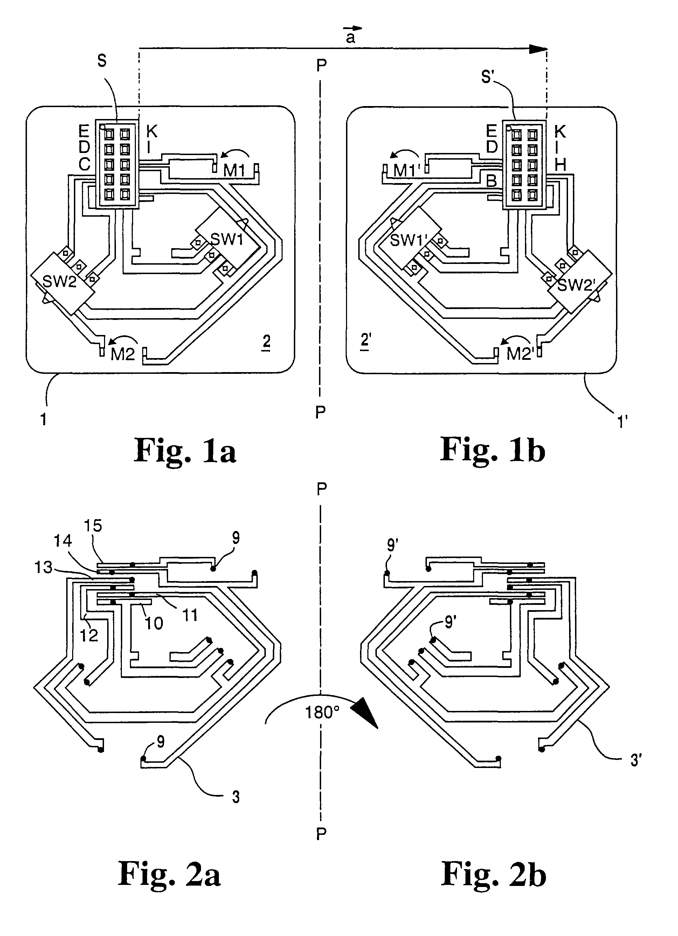

Fig. 1a und 1b zeigen eine erfindungsgemäße Schaltungsträgeranordnung, welche eine linkshändigen 2 und einen dazu längs einer Spiegelebene P in räumlich-geometrischer Hinsicht spiegelsymmetrischen rechtshändigen Schaltungsträger 2' umfaßt. Bei den Schaltungsträgern 2, 2' sind in einer Gehäuseschale 1, 1' auf einem in einem Kunststoffmantel eingebetteten Stanzgitter elektrische und/oder elektronische und/oder elektromechanische Bauteile wie Schalter SW1 bzw. SW1', SW2 bzw. SW2', Elektromotoren M1 bzw. M1', M2 bzw. M2' und Kontaktstecker S bzw. S' positioniert, welche mit dem eingebetteten Stanzgitter elektrisch in Kontakt stehen.

Diese Bauteile sind bei der linkshändigen und der rechtshändigen Variante des Schaltungsträgers 2, 2' spiegelsymmetrisch zur Spiegelebene P positioniert und orientiert.

Jedoch sind im linken und im rechten Schaltungsträger jeweils genau identische Bauteile verwendet. Der Schalter SW1 auf dem linkshändigen Schaltungsträger ist also identisch zum Schalter SW1' auf dem rechtshändigen Schaltungsträger, der Schalter SW2 auf dem linkshändigen Schaltungsträger ist identisch zum Schalter SW2' auf dem rechtshändigen Schaltungsträger. Gleiches gilt für die Elektromotoren M1 und M1' sowie M2 und M2'. Diese drehen sich in der linkshändigen und der rechtshändigen Variante des Schaltungsträgers 2 bzw. 2' jeweils gleichsinnig (gegen den Uhrzeigersinn) und nicht zueinander gegensinnig. Weiterhin sind bei den Steckern S und S' die Kontaktbelegungen A bis K bzw. A' bis K' nicht spiegelsymmetrisch zueinander angebracht. Vielmehr kann man sich den Stecker S' auf dem rechtshändigen Schaltungsträger 2' aus dem Stecker S auf dem linkshändigen Schaltungsträger 2 dadurch hervorgegangen denken, daß man den Stecker S in Fig. 1a durch eine translatorische Verschiebung senkrecht zur Spiegelebene P um den Pfeil a nach rechts verschiebt.

Der linkshändige Schaltungsträger 2 in Fig. 1a und der rechtshändige Schaltungsträger 2' in Fig. 1b sind also in räumlich-geometrischer Hinsicht spiegelsymmetrisch, wegen der Gleichsinnigkeit der Motordrehbewegungen und der exakt gleichen Kontaktbelegung A bis K auf den beiden Schaltungsträgern jedoch schaltungsfunktionell asymmetrisch zueinander.

Die beiden Schaltungsträger 2, 2' in Fig. 1a und 1b umfassen Leiteranordnungen 3 bzw. 3' in Form von elektrisch leitenden Stanzgittern, wie in Fig, 2a und 2b gezeigt. Dabei sind in beiden Schaltungsträgern 2, 2' exakt identische Stanzgitter eingesetzt. Das im rechten Schaltungs träger 2 eingesetzte Stanzgitter geht also aus dem im linken Schaltungsträger eingesetzten Schaltungsträger 2 verwendeten Stanzgitter durch Spiegeln an der Spiegelebene P hervor. In der Materialwirtschaft kann somit auf einen einzigen Stanzgittertyp zurückgegriffen werden, der bei Verwendung im linkshändigen Schaltungsträger auf einer vorbestimmten Seite mit Bauteilen bestückt wird, und bei Verwendung im rechtshändigen Schaltungsträger auf der gegenüberliegenden Seite mit Bauteilen bestückt wird.

Bei einem metallischen Stanzgitter, bei dem die Gitterabschnitte in ihrem gesamten Volumen elektrisch leitend sind und elektrisch kontaktiert werden können, erfolgt dies durch Anlöten oder Ankleben oder Anschweißen von Kontaktstiften oder Kontaktfahnen der Bauteile auf einer Seite eines Stanzgitters bzw. der gegenüberliegenden Seite. Durch die Verwendung zweier zueinander symmetrischer Stanzgitter muß nur ein Stanzwerkzeug vorgehalten werden.

In Fig. 2a und 2b veranschaulichen die schwarz eingezeichneten Kreise 9 bzw. 9' Positionen, an denen die Anschlußkontakte der in Fig. 1a und 1b gezeigten Bauteile (Stecker S bzw. S', Motoren M1, M2 bzw. M1', M2' und Schalter S1, S2 BZW. S1', S2') mit den Stanzgittern in Verbindung gebracht werden. Bevorzugterweise werden die links- und die rechtshändige Variante des Stanzgitters an diesen Punkten 9, 9' in einem für die beiden Varianten jeweils separat durchzuführenden Fertigungsschritt mit Kontaktstiften oder Kontaktfahnen versehen. Dies kann durch gängige Verfahren wie Anschweißen, Anlöten oder im Prinzip auch durch Ankleben von Kontaktstiften oder Kontaktfahnen erfolgen. An die so vorkonfektionierten Stanzgitter lassen sich dann in besonders einfacher Weise die Kontakte von Bauelementen anschließen.

Bei der Serienfertigung von Automobiltürschließvorrichtungen ist insbesondere wegen der Verwendung von identischen Steckern S bzw. S' und Motoren auf das Erfordernis der funktionalen Asymmetrie bei den auf dem linkshändigen bzw. rechtshändigen Schaltungsträgern aufgebrachten Steckern und Motoren zu achten.

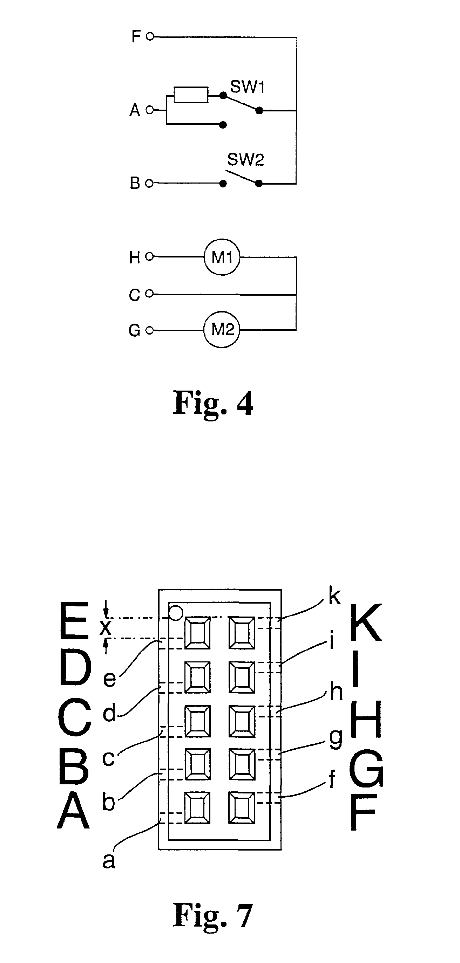

Um hierbei Probleme bei der Gestaltung des Layouts der Leiteranordnungen für eine erfindungsgemäße Schaltungsträgeranordnung zu minimieren, wird bevorzugterweise eine in Fig. 7 gezeigte Anordnung für die Kontaktanschlüsse eines Steckers S bzw. S' und die daran zu kontaktierenden Leiterabschnitte der Leiteranordnung für eine erfindungsgemäße Schaltungsträgeranordnung gewählt:

Wie in Fig. 7 gezeigt, ist ein Stecker S mit zweireihig parallel nebeneinanderliegend angeordneten Steckkontakten A bis K versehen, d.h. einer ersten Reihe von Steckkontakten A bis E und einer zweiten Reihe von Steckkontakten F bis K. Der ersten Reihe von Steckkontakten A bis E zugeordnete Kontaktanschlüsse a bis e sind um eine Versatzstrecke x relativ zu den der zweiten Reihe von Steckkontakten F bis K zugeordneten Kontaktanschlüssen f bis k angeordnet.

Bei der Festlegung eines Layouts für eine in einer erfindungsgemäßen Schaltungsträgeranordnung einzusetzenden Leiteranordnung werden nunmehr auf zu den Steckkontakten A und F, B und G, C und H korrespondierenden Leiteranordnungsabschnitten 10 und 11, 12 und 13, 13 und 14 (Fig. 2a) ebenfalls zweireihig parallel nebeneinanderliegend angeordnet, wie dies in Fig. 1a bzw. 1b zu sehen ist, und zwar so, daß unterhalb eines Paars von Steckkontakten A und F, B und G, C und H jeweils zwei Leiteranordnungsabschnitte parallel zueinander verlaufen. Durch diese Anordnung von Leiteranordnungsabschnitten ist sichergestellt, daß die linkshändige Variante, bei der der Stecker S das Stanzgitter an einer ersten Seite kontaktiert, als auch die dazu "umgedrehte" rechtshändige Variante, bei der der entsprechende Stecker S' an der gegenüberliegenden Seite kontaktiert, wie im Schaltplan (Fig. 4) vorgesehen, angeschlossen werden können. Im vorliegenden Beispiel werden gemäß dem in Fig. 4 gezeigten Schaltplan die Steckkontakte D und I, E und K nicht kontaktiert.

Durch diese Maßnahme ist sichergestellt, daß sämtliche zu kontaktierenden Kontaktanschlüsse a, b, c, f, g, h der Steckkontakte A bis C sowie F bis H des Steckers sowohl auf dem in Fig. 2a gezeigten linkshändigen Schaltungsträger 2 als auch auf dem in Fig. 2b gezeigten, um 180° dazu umgeklappten (an der Spiegelebene P gespiegelten), also rechtshändigen Schaltungsträger 2', mit den Leiteranordnungsabschnitten 10 bis 15 (Fig. 2a) auf der Leiteranordnung 3, 3' in Kontakt treten können.

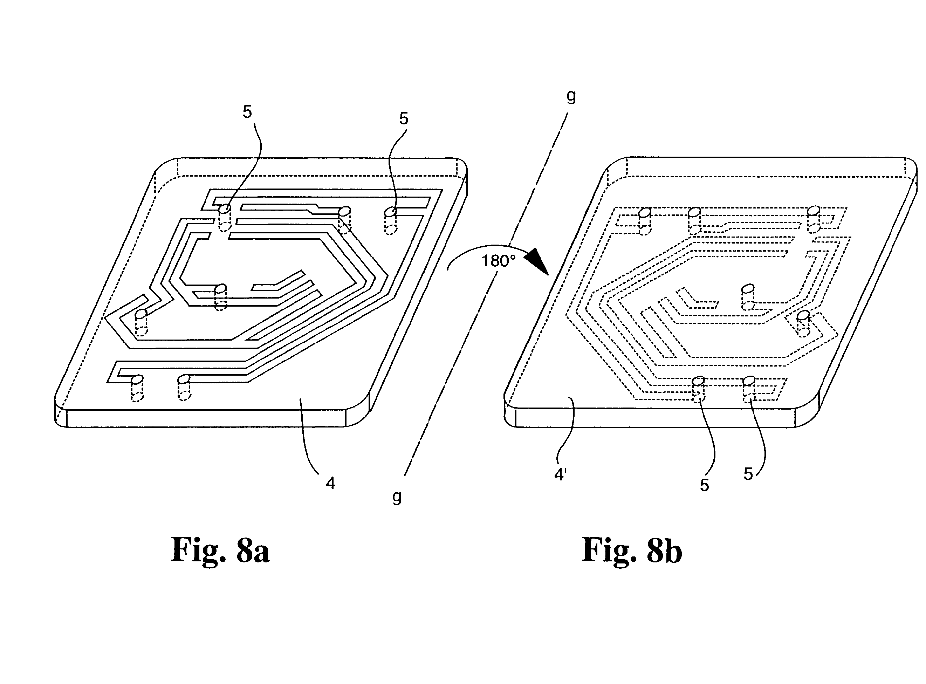

Anstelle eines Stanzgitters, welches bei Verwendung in einem rechtshändigen Schaltungsträger anstelle in einem linkshändigen an einer Spiegelebene zu spiegeln ist, und von beiden Seiten her mit Bauelementen direkt kontaktierbar ist, können in einer erfindungsgemäßen Schaltungsträgeranordnung auch nur einseitig mit Leiterbahnen versehene starre Leiterplatten oder flexible Leiterfolien verwendet werden. Dies ist in Fig. 8a und 8b gezeigt. Dabei sind zwei zueinander identische, in einer erfindungsgemäßen Schaltungsträgeranordnung zur Verwendung für einen linkshändigen und einen rechtshändigen Schaltungsträger ausgerichtete, einseitig mit Leiterbahnen versehene Leiterträger 4, 4' in perspektivischer Ansicht gezeigt.

In Fig. 8a ist ein einseitig mit Leiterbahnen versehener Leiterträger 4 zur Verwendung in einem linkshändigen Schaltungsträger gezeigt. In Fig. 8b ist ein zu dem in Fig. 8a gezeigten Leiterträger vollkommen identischer Leiterträger zur Verwendung in einem rechtshändigen Schaltungsträger gezeigt. Den in Fig. 8b gezeigten Leiterträger kann man sich aus dem in Fig. 8a gezeigten Leiterträger dadurch hervorgegangen denken, daß der letztere längs der zwischen den beiden Leiterträgern gezeigten Achse um 180° umgeklappt worden ist.

Der Leiterträger 4, 4' enthält auf seinen Leiterbahnen dort, wo Bauteile anzubringen sind, Durchbohrungen 5, die innenwandig mit Leitermaterial ausgekleidet sind. Dadurch ist es an diesen nur einseitig mit Leiterbahnen versehene Leiterträgern möglich, diese gleichwohl beidseitig mit Bauelementen zu bestücken. Man kann so auch nur einseitig mit Leiterbahnen versehenen Leiterträger in einer erfindungsgemäßen Schaltungsträgeranordnung für die linkshändige und die rechtshändige Schaltungsträgervariante einsetzen.

## Patentansprüche

1. Schaltungsträgerordnung, welche einen linkshändigen (2) und einen dazu identischen rechtshändigen (2') Schaltungsträger mit jeweiligen elektrischen und/oder elektronischen und/oder elektromechanischen Bauelementen (SW1, SW2, M1, M2, S bzw. SW1', SW2', M1', M2', S') und einer diese Bauelemente elektrisch verbindenden Leiteranordnung (3 bzw, 3') umfaßt, wobei bei Ausrichtung des linkshändigen (2) und des rechtshändigen (2') Schaltungsträgers längs einer Spiegelebene (P) Bauelemente (SW1, SW2, M1, M2 bzw. SW1', SW2', M1', M2') auf dem linkshändigen (2) bzw. dem rechtshändigen (2') Schaltungsträger in symmetrisch gespiegelter Weise positioniert sind, wohingegen sich die schaltungsfunktionellen Kontaktbelegungen (A - F) mindestens eines schaltungsfunktionell spiegelungsinvarianten Bauteils (S') auf dem rechtshändigen (1') Schaltungsträger durch eine translatorische Verschiebung senkrecht zu der Spiegelebene (P) aus den schaltungsfunktionellen Kontaktbelegungen (A - F) des korrespondierenden schaltungsfunktionell spiegelungsinvarianten Bauelements (S) auf dem linkshändigen (2) Schaltungsträger ergeben, und wobei die Leiteranordnung auf dem linkshändigen Schaltungsträger durch Umklappen um 180° um eine in der Spiegelebene (P) liegende Drehachse (g) in die Leiteranordnung auf dem rechtshändigen Schaltungsträger übergeführt werden kann.

2. Schaltungsträgeranordnung nach Anspruch 1, wobei das mindestens eine schaltungsfunktionell spiegelungsinvariante Bauteil ein Stecker (S, S') mit zweireihig parallel nebeneinanderliegend angeordneten Steckkontakten (A bis K) ist, wobei die Kontaktanschlüsse (a bis e) der ersten Reihe von Steckkontakten (A bis E) um eine zur Längsachse des Steckers parallelen Versatzstrecke (x) relativ zu den Kontaktanschlüssen (f bis k) der zweiten Reihe von Steckkontakten (F bis K) versetzt angeordnet sind, und wobei zu den Steckkontakten korrespondierende Leiteranordnungsabschnitte (10 bis 15) ebenfalls zweireihig parallel nebeneinanderliegend so angeordnet sind, daß jeweils ein Paar von Leiteranordnungsabschnitten (10 und 11, 12 und 13, 14 und 15) unter je einem Paar von Steckkontakten (A und F, B und G, C und H) verläuft.

3. Schaltungsträgeranordnung nach einem der Ansprüche 1 oder 2, wobei die Bauelemente auf dem linkshändigen Schaltungsträger auf einer Seite eines ersten Stanzgitters angebracht sind, und die Bauelemente auf dem rechtshändigen Schaltungsträger auf der gegenüberliegenden Seite eines zum ersten Stanzgitter identischen zweiten Stanzgitters angebracht sind.

4. Schaltungsträgeranordnung nach Anspruch 3, wobei an dem ersten Stanzgitter und an dem zweiten Stanzgitter jeweils Kontaktstifte und/oder Kontaktfahnen durch Anschweißen, Anlöten oder Ankleben so angebracht sind, daß sie eine Kontaktierung der schaltungsfunktionell spiegelungsinvarianten Bauteile auf dem linkshändigen Schaltungsträger (erstes Stanzgitter) und dem rechtshändigen Schaltungsträger (zweites Stanzgitter) ermöglichen.

5. Schaltungsträgeranordnung nach einem der Ansprüche 1 bis 3, wobei die Bauelemente auf dem linkshändigen Schaltungsträger auf der Leiterbahnen tragenden Seite eines mit Leiterbahnen einseitig versehenen ersten Leiterträgers angebracht sind, und die elektromechanischen Bauelemente auf dem rechtshändigen Schaltungsträger auf der anderen Seite eines zum ersten Lei terträger identischen zweiten Leiterträgers angebracht sind und durch Durchbohrungen durch den Leiterträger hindurch mit den Leiterbahnen elektrisch verbunden sind.

6. Schaltungsträgeranordnung nach Anspruch 5, wobei der Leiterträger eine starre Leiterplatte ist.

7. Schaltungsträgeranordnung nach Anspruch 5, wobei der Leiterträger eine flexible Leiterplatte ist.

8. Schaltungsträgeranordnung nach Anspruch 5, wobei der Leiterträger eine flexible Leiterfolie ist.
